# EUROPEAN PATENT SPECIFICATION

(11) **EP 2 510 523 B1**
(45) Date of publication and mention of the grant of the patent: **17.05.2017**
(21) Application number: 10744493.7
(22) Date of filing: 22.01.2010
(51) Int. Cl.: G21K 1/08, H01J 37/141

(54) **A MULTI-AXIS MAGNETIC LENS**
MEHRACHSIGE MAGNETISCHE LINSE
LENTILLE MAGNÉTIQUE À AXES MULTIPLES

(30) Priority: 11.12.2009 US 636007
(43) Date of publication of application: 17.10.2012
(73) Proprietor: Hermes Microvision Inc., East Dist., Hsinchu City 300 (TW)
(72) Inventor: CHEN, Zhongwei, San Jose, CA 95129 (US); REN, Weiming, San Jose, CA 95131 (US); KANAI, Kenichi, Palo Alto, CA 54303 (US); LIU, Xuedong, Cupertino, CA 95014 (US)
(74) Representative: Karakatsanis, Georgios
(86) International application number: PCT/US2010/021722
(87) International publication number: WO 2011/071549

(56) References cited:
- DE-A1- 3 010 814
- JP-A- 2002 150 989
- US-A1- 2001 028 046
- US-A1- 2009 108 199
- US-A1- 2009 261 266
- US-B2- 7 253 417

## Description

### FIELD OF THE INVENTION

The present invention relates to a multi-axis magnetic lens for a charged particle beam system. More specifically, it relates to a charged particle optics apparatus with a non-magnetic material gap between a magnetic insert ring and a magnetic conductor plate for eliminating a non-axisymmetric transverse magnetic field due to an asymmetric structure thereof.

### BACKGROUND OF THE INVENTION

Defect inspection of semiconductor wafers and masks for IC manufacturing is an accepted production process for yield enhancement. The information obtained from a wafer defect inspection tool can be used to flag defective dies for repair, or improve wafer processing parameters. The systems used for inspection were typically optical system in nature and such systems were limited in resolution due to the wavelength of measuring light. Electron beam systems can have much higher resolution than optical systems because the wavelength of the electron can be in the angstrom regime. However, the electron beam systems are limited in speed at which they can inspect wafers. Depending on the scanning frequency, the present systems with throughput varying from 20 to 40 square cm per hour have been achieved. Thus to inspect an entire 300 mm diameter silicon wafer, at least 18 hours will be required. In order to achieve a throughput of several wafers per hour, (which is suitable for in-line use in a semiconductor fabrication facility), the idea of multi-axis magnetic lens system for charged particle beam was introduced.

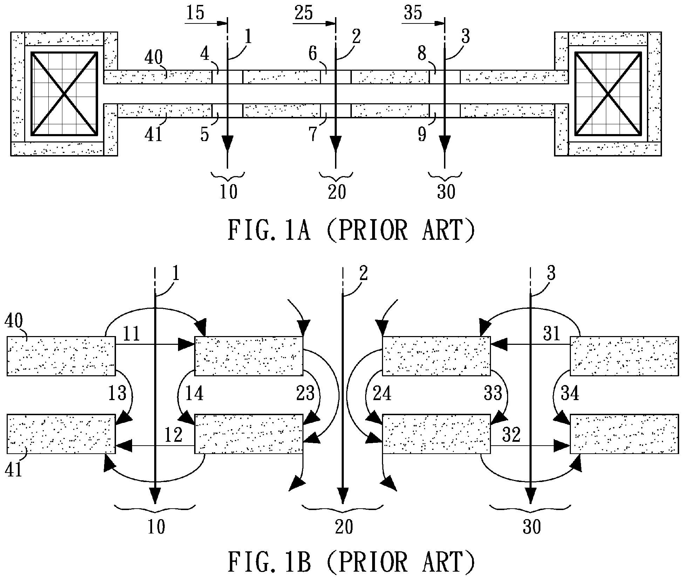

The first multi-electron-beam patent was granted to Maekawa et al. in 1973 for a throughput improvement exposure system. The apparatus consists of one common excitation coil and two magnetic conductor plates with a plurality of through holes each for the corresponding particle beam passing, which was proposed in US 3,715,580 and was illustrated in Fig. 1A. Between a pair of holes in the upper magnetic conductor plate 40 and the lower magnetic conductor plate 41 such as hole 4 and hole 5, a sub-lens or sub-lens module such as 10 is formed. The two magnetic conductor plates 40 and 41 are the pole pieces of these sub-lenses (10, 20 and 30). For this type lens, the magnetic fields of the sub-lenses are fundamentally different from each other in magnetic field distribution and magnetic field strength (Fig. 1B).

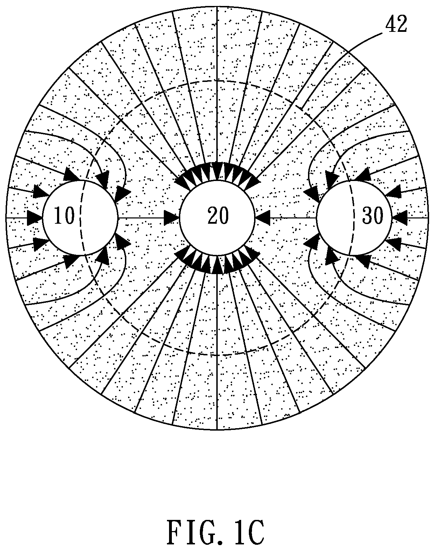

Comparing with the conventional single-axis magnetic lens, the field distribution of the sub-lens degenerates from axial symmetry to rotation symmetry and/or n-fold symmetry (Fig. 1B, Fig. 1C). As a result, besides the axisymmetric field, the non-axisymmetric transverse field components called as high order harmonics such as dipole field (11, 12, 31, 32 in Fig. 1B) and quadrupole field 42 (Fig. 1C) appear. The dipole field deflects the charged particle beam, and makes the beam land on the imaging plane with an additional transverse shift, an additional tilt angle and additional aberrations. The quadrupole field adds astigmatism to the beam. The appearance of the harmonics requires the optics includes at least one additional element generating the same type field to compensate the influence of each corresponding harmonic.

The magnetic flux passing through the center sub-lens 20 and peripheral sub-lenses 10, 30 are not same because they are located in the areas of the two magnetic conductor plates 40 and 41 with different magnetic flux. This difference makes the axisymmetric field called as round lens field of the center sub-lens 20 a little different from that of the peripheral sub-lenses 10, 30. As a result, the center beam 2 passing through the center sub-lens 20 and the peripheral beams 1 and 3 passing through the peripheral sub-lenses 10 and 30 respectively are not focused at the same imaging plane (Figure 1A).

Many scientists who followed Maekawa's foot steps have tried many methods to eliminate the influences of the high order harmonics and the round lens field differences among all the sub-lenses.

US 6750455 of Lo et al. reduces the dipole field itself by using plurality of dummy holes to improve the local structure symmetry of the sub-lens the beam will really pass.

US 6777694 of Haraguchi compensates the dipole field influence by inserting a deflector group in each sub-lens hole.

By varying the thicknesses of some areas of one of the two magnetic conductor plates, DE 30 10 814 of Anger Klaus et al. eliminates the round lens field differences among all the sub-lenses. US 6703624 of Hamaguchi et al., US 2001/0028046 of Hamaguchi et al and JP 2002 150989 of Haraguchi insert a pair of magnetic insert rings in each pair of holes, which accordingly function as a pair of magnetic pole pieces of the sub-lens. In these three documents, the same problem is solved by changing the pole piece diameter or the pole piece gap size of the sub-lens to control the magnetic flux leakage in the individual sub-lens.

US 6703624 of Hamaguchi et al. and US 7253417 of Frosien et al. compensate the round lens field differences by inserting an auxiliary round coil or an electrostatic lens in each sub-lens.

These previous methods were either making the magnetic conductor plate larger and the multi-axis magnetic lens system bulky or making it complicated, and could only compensate the influences of high order harmonics partially. The present invention will provide a better solution that eliminates high order harmonics per se along the charged particle beam path. Therefore it provides a high throughput inspection tool for semiconductor yield enhancement.

### SUMMARY OF THE INVENTION

The present invention relates to a plurality of sub-lens modules as defined in claim 1, and a multi-axis magnetic lens comprising said plurality of sub-lens modules for a charged particle beam system, as defined in claim 2. The multi-axis magnetic lens eliminates the undesired non-axisymmetric transverse magnetic field components called as high order harmonics from the magnetic field generated by a common excitation coil and leaves the desired axisymmetric field components called as round lens fields for respectively focusing each particle beam employed within the system. However, it would be recognized that the invention has a much broader range of applicability.

The present invention provides several embodiments of the multi-axis magnetic lens that eliminate the high order harmonics of the magnetic field on the charged particle beam path with respect to each sub-lens. The high order harmonics of the magnetic field are generated by geometric symmetry variation when the lens structure is altered from single axis to multi-axis.

One aspect of the invention is to utilize a higher permeability magnetic insert ring in each hole of each sub-lens to create permeability discontinuity. In this case, the magnetic insert rings inserted in the upper and lower magnetic conductor plates function as a pair of pole pieces of the sub-lens. This design weakens the non-axisymmetric distribution of magnetic scalar potential inside each magnetic ring and as a result reduces the high order harmonics of the magnetic field.

The invention further separates the magnetic insert ring from the inner sidewall of the hole by a gap which is a vacuum space or filled with a non-magnetic material to form magnetic permeability discontinuity. The magnetic insert ring is aligned with the hole. The magnetic insert rings inserted in the upper and lower magnetic conductor plates function as a pair of pole pieces of the sub-lens. This design makes an efficient shield of the high order harmonics of the magnetic field within the sub-lens. A multilayer gap including alternately placed non-magnetic material layer and magnetic material layer makes the shielding more efficient.

A preferred embodiment introduces magnetic shielding tubes that sit on/under a vacuum gap or a non-magnetic material lining above the upper magnetic conductor and below the lower magnetic conductor plate. Each magnetic shielding tube is aligned with each hole in each sub-lens to surround each charged particle beam path. This design makes an efficient shielding along the beam path of each beam from the charged particle source through the sub-lens to the imaging plane. A multilayer shielding can further improve the shielding effect.

Another embodiment of the present invention extends the magnetic insert ring on the upper magnetic conductor plate upward to the upper magnetic shielding tube and the magnetic insert ring on the lower magnetic conductor plate downward to the lower magnetic shielding tube to cover the distance between the magnetic insert ring and the magnetic shielding tube.

Another embodiment of the present invention extends the magnetic insert ring on the upper magnetic conductor plate into the magnetic insert ring on the lower magnetic conductor plate as a pair of pole pieces. This design is for eliminating the small residual high order harmonics of the magnetic field between the upper and lower magnetic conductor plates.

Another embodiment introduces two magnetic shielding houses to cap the path of all the charged particle beams respectively above the upper magnetic conductor plate and below the lower magnetic conductor plate, instead of magnetically shielding each individual charged particle beam by a magnetic shielding tube. Each magnetic shielding house has a top lid and a bottom plate with a polarity of holes that match with the corresponding incident beams and is separated by a vacuum gap or a non-magnetic material lining from the corresponding magnetic conductor plate. This design shields out most of the undesired magnetic fields inside the house, however, there still is some magnetic field leak near the opening position close to the corresponding magnetic conductor plate.

Another embodiment replaces the magnetic shielding tubes or the magnetic shielding house below the lower magnetic conductor plate by a magnetic shielding plate separated from the latter by a vacuum gap or a non-magnetic material lining and having a plurality of openings respectively aligned with the plurality of holes of the lower magnetic conductor plate.

Another embodiment utilizes the thickness of the non-magnetic material gap or the multilayer gap to adjust the magnetic flux leakage in each sub-lens, and finally makes all the sub-lenses have same round lens fields.

The present invention therefore can provide a nearly high order harmonics free environment for each charged particle beam in a multi-column charged particle beam apparatus if which employs a foregoing embodiment of the multi-axis magnetic lens The multi-axis magnetic lens could be used as condenser lens or objective lens in the multi-column apparatus.

A multi-axis magnetic lens therefore is provided, which comprises a pair of parallel magnetic conductor plates, a common excitation coil, a plurality of magnetic insert rings in pairs, and a plurality of gaps in pairs. The pair of parallel magnetic conductor plates includes a plurality of holes in pairs, wherein for each paired holes, an upper hole in an upper magnetic conductor plate of the pair of parallel magnetic conductor plates is aligned with a lower hole in a lower magnetic conductor plate of the pair of parallel magnetic conductor plates. For each paired magnetic insert rings, an upper magnetic insert ring and a lower magnetic insert ring are respectively inserted in and aligned with the upper hole and the lower hole of each paired holes. The feature of this invention is to configure one paired gaps between each paired holes and each paired magnetic insert rings therein. For each paired gaps, an upper gap is inserted between the outer sidewall of the upper magnetic insert ring and the inner sidewall of the upper hole and a lower gap is inserted between the outer sidewall of the lower magnetic insert ring and the inner sidewall of the lower hole. In this way, a plurality of sub-lens modules are formed, wherein each sub-lens module consists of a pair of holes, the corresponding pair of magnetic insert rings therein functioning as a pair of pole pieces and the corresponding pair of gaps there between. The common excitation coil provides a magnetic flux to the plurality of sub-lens modules, wherein each sub-lens module can focus a charged particle beam therethrough.

Each gap may have one vacuum layer or be filled with one non-magnetic material layer, and all the gaps may have the same or different thicknesses. Each gap may include a multilayer. The multilayer may comprise at least one magnetic layer and two non-magnetic layers and the magnetic layer is sandwiched between the two non-magnetic layers. The multilayer may comprise at least two magnetic layers and at least three non-magnetic layers, wherein the magnetic layers and the non-magnetic layers are interleaved.

The multi-axis magnetic lens can further comprise a plurality of magnetic shielding tubes, wherein each shielding tube matches each hole in each sub-lens module from outside and is separated from each magnetic conductor plate by a vacuum gap or a non-magnetic lining. Each upper magnetic insert ring is extended upward to cover the distance between it and the corresponding magnetic shielding tube above the upper magnetic conductor plate; and each lower magnetic insert ring is extended downward to cover the distance between it and the corresponding magnetic shielding tube below the lower magnetic conductor plate. The multi-axis magnetic lens can also further comprise a magnetic shielding plate or a magnetic shielding house above the upper magnetic conductor plate or/and below the lower magnetic conductor plate.

In each sub-lens module, the upper magnetic insert ring can be extended downward into the lower magnetic insert.

### BRIEF DESCRIPTION OF THE DRAWINGS

The present invention will be readily understood by the following detailed description in conjunction with the accompanying drawings, wherein like reference numerals designate like structural elements, and in which:
Figure 1A is a schematic diagrammatic representation of a basic multi-axis lens (Prior Art).
Figure 1B is a schematic diagrammatic representation of magnetic flux lines in the six holes of Figure 1A (Prior Art).
Figure 1C is a schematic diagrammatic representation of top view of magnetic flux lines in the upper magnetic conductor plate of Figure 1B.
Figure 2A is a schematic diagrammatic representation of Model 1, the fundamental structure of a prior art multi-column system, for explaining an embodiment of the present invention.
Figure 2B is a schematic diagrammatic representation of the top view of A-A section of Figure 2A with a round shaped structure.
Figure 2C is another schematic diagrammatic representation of top view of A-A section of Figure 2A with a rectangular shaped structure.
Figure 2D is a schematic diagrammatic representation of a simulation result of the dipole field distribution along the optical axis 35 of the peripheral sub-lens 30 of Model 1 shown in Figure 2A and Figure 2B.
Figure 2E is a schematic diagrammatic representation of a simulation result of the quadrupole field distribution along the optical axis 35 of the peripheral sub-lens 30 of Model 1 shown in Figure 2A and Figure 2B.
Figure 3A is a schematic diagrammatic representation of Model 2, the structure of a magnetic insert ring inside a hole on the upper magnetic conductor plate, according an embodiment of the present invention.
Figure 3B is a schematic diagrammatic representation of a simulation result of the dipole field distribution along the optical axis 35 of the peripheral sub-lens 30 of Model 2.
Figure 4A is a schematic diagrammatic representation of Model 3, the structure of a magnetic insert ring and a non-magnetic material gap on the upper magnetic conductor plate, according an embodiment of the present invention.
Figure 4B is a schematic diagrammatic representation of a simulation result of the dipole field distribution along the optical axis 35 of the peripheral sub-lens 30 of Model 3.
Figure 4C is a schematic diagrammatic representation of an example of the multilayer gap, according an embodiment of the present invention.
Figure 5A is a schematic diagrammatic representation of Model 3 structure plus the magnetic shielding tubes, according an embodiment of the present invention.
Figure 5B is a schematic diagrammatic representation of a simulation result of the dipole field distribution along the optical axis 35 of the peripheral sub-lens 30 of the model shown in Figure 5A.
Figure 6A is a schematic diagrammatic representation of model 3 structure plus the magnetic shielding tubes, wherein the magnetic insert ring is extended into the magnetic shielding tube according an embodiment of the present invention.
Figure 6B is a schematic diagrammatic representation of a simulation result of the dipole field distribution along the optical axis 35 of the peripheral sub-lens 30 of the model shown in Figure 6A.
Figure 7 is a schematic diagrammatic representation of dipole field comparison of the peripheral sub-lens 30 in Model 1 shown in Figure 2A and the model shown in Figure 6A.
Figure 8A is a schematic diagrammatic representation of Model 4, the structure of a magnetic insert ring and a non-magnetic material gap in each hole of the magnetic conductor plate, wherein the magnetic insert ring on the upper magnetic conductor plate is extended into the magnetic insert ring on the lower magnetic conductor plate.
Figure 8B is a schematic diagrammatic representation of a simulation result of the, dipole field distribution along the optical axis 35 of the peripheral sub-lens 30 of the model 4 shown in Figure 8A.
Figure 9 is a schematic diagrammatic representation of dipole field comparison of the peripheral sub-lens 30 in Model 1 shown in Figure 2A and Model 4 shown in Figure 8A.
Figure 10A is a schematic diagrammatic representation of model 3 structure plus two magnetic shielding houses covering all the charged particle beams, according an embodiment of the present invention.
Figure 10B is a schematic diagrammatic representation of a simulation result of the dipole field distribution along the optical axis 35 of the peripheral sub-lens 30 of the model shown in Figure 10A.
Figure 11 is a schematic diagrammatic representation of an example in which the present invention is functioned as an objective lens.
Figure 12 is a schematic diagrammatic representation of a method to eliminate the round lens field differences among all the sub-lenses, according an embodiment of the present invention.

### DETAILED DESCRIPTION OF THE INVENTION

Reference will now be made in detail to specific embodiments of the invention. Examples of these embodiments are illustrated in accompanying drawings. While the invention will be described in conjunction with these specific embodiments, it will be understood that it is not intended to limit the invention to these embodiments. On the contrary, it is intended to cover alternatives, modifications, and equivalents insofar they are included within the scope of the invention as defined by the appended claims. In the following description, numerous specific details are set forth in order to provide a through understanding of the present invention. The present invention may be practiced without some or all of these specific details. In other instances, well known process operations are not described in detail in order not to unnecessarily obscure the present invention.

The present invention relates to a multi-axis magnetic lens for a multi-column charged particle beam system or apparatus. The lens eliminates the undesired non-axisymmetric transverse magnetic field components from the magnetic field generated by a common excitation coil and leaves the desired axisymmetric fields for respectively focusing each particle beam employed within the system. Although all the discussion in the present invention based on a structure of 3 sub-lenses, however, it would be recognized that the invention can be applied to a structure with more than three sub-lenses and has a much broader range of applicability.

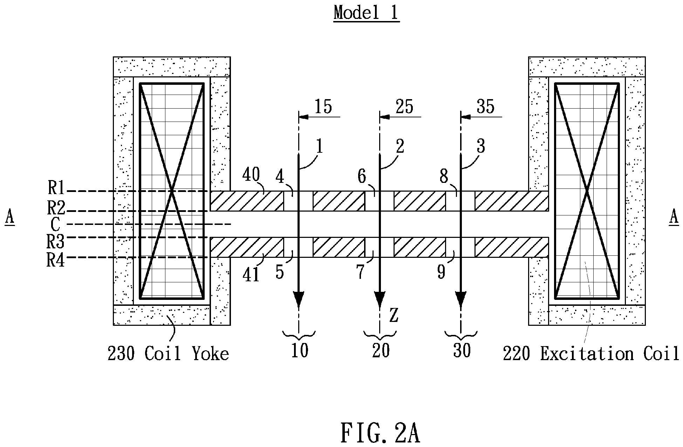

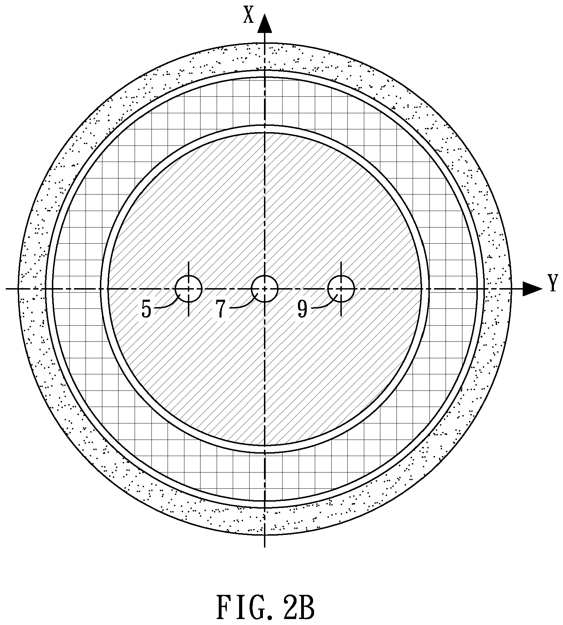

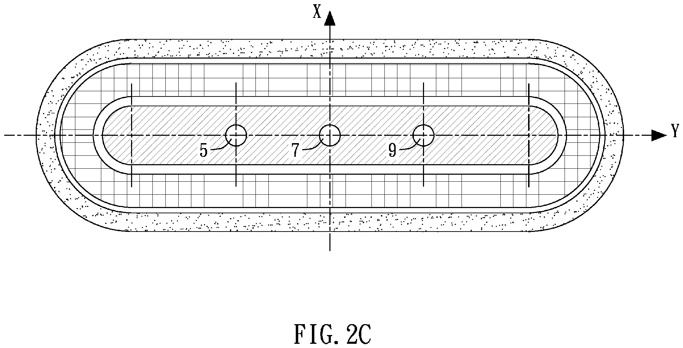

The conventional multi-electron-beam lens structure or called as multi-axis lens that designed by Maekawa is illustrated in Figure 2A. It is also a basic structure, Model 1, of the present invention. The structure has a common excitation coil 220 covered by a coil yoke 230 and two magnetic conductor plates 40 and 41, wherein the magnetic conductor plate 40 is an upper magnetic conductor plate and the magnetic conductor plate 41 is a lower magnetic conductor plate. Three holes 4, 6, 8 in the upper magnetic conductor plate 40 and the corresponding holes 5, 7, 9 in the lower magnetic conductor plate 41 form three sub-lenses or sub-lens modules 10, 20 and 30, wherein each sub-lens module focuses a charged particle beam. The common excitation coil 220 provides a magnetic flux to the sub-lens modules 10, 20 and 30. The coil yoke 230 is made of a material that has a lower permeability for example 1000. The magnetic conductor plates 40 and 41 are made of a material with a higher permeability for example 5000 or higher. The top view of A-A section of this multi-axis magnetic lens is illustrated in Figure 2B. Although the round shape structure is chosen as an example, however, the shape of the multi-axis magnetic lens for a multi-column charged particle beam system in the present invention can be in any shape. A rectangular shaped apparatus is illustrated in Figure 2C.

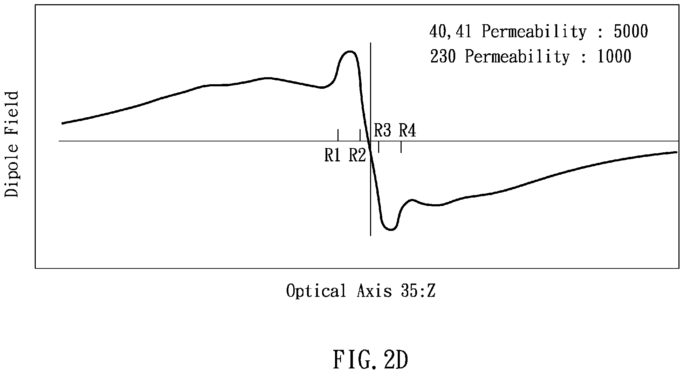

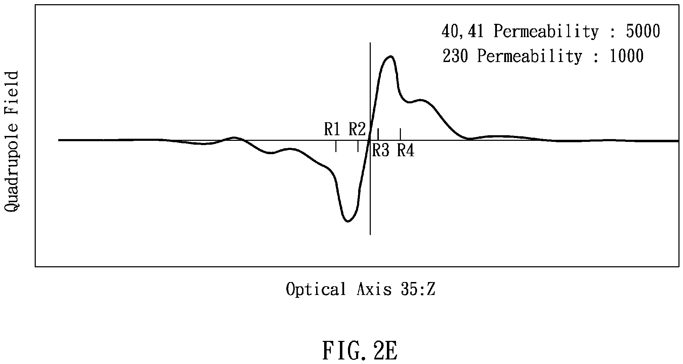

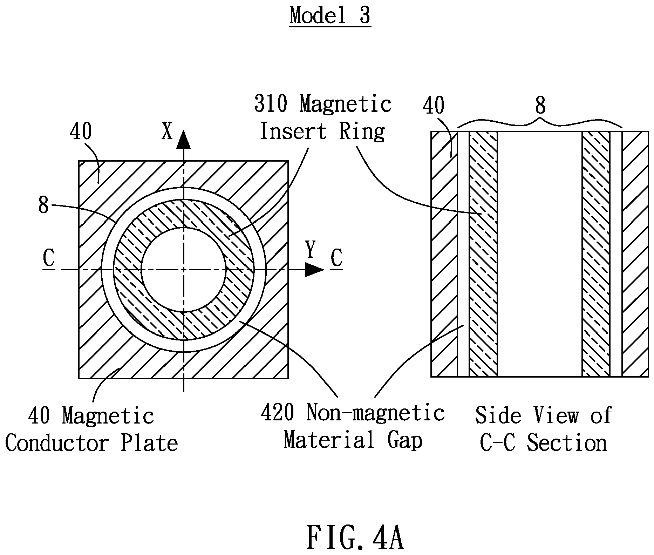

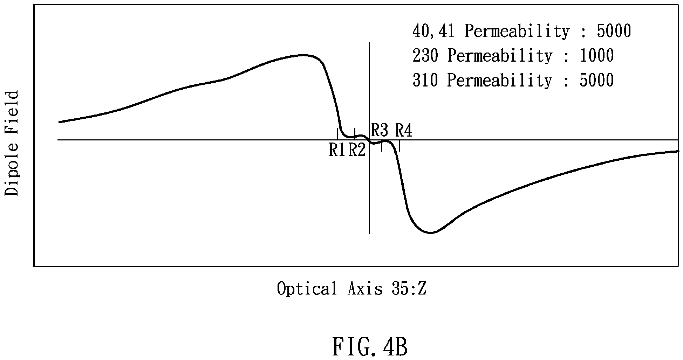

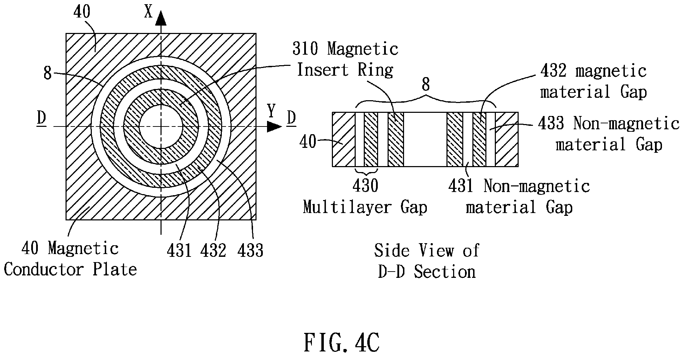

The peripheral sub-lenses 10 and 30 have a dipole field and a quadrupole field. Figure 2D and Figure 2E show the dipole field and quadrupole field distributions of sub-lens 30 along its optical axis 35, wherein permeabilities of plates 40 and, 41 are 5000 and coil yoke 230 is 1000. The sub-lens 20 has no dipole field because of its 2-fold symmetry. The present invention chooses the peripheral sub-lens 30 as an example to discuss the variation of the high order harmonics of the magnetic field in each embodiment. In this embodiment, although a dipole field and a quadrupole field in only the sub-lens 30 are solved, other peripheral sub-lens, such as 10 can also be solved in the same way. Although many high order harmonics exist in the sub-lens 30, the present invention will primarily focus on the variation of the first order harmonic called as the dipole field as an example. This is because other high order harmonic fields have the same variation trend as the dipole field varies. In Figure 2A, 4 markers R1, R2, R3, and R4 respectively correspond to the positions of the top and the bottom surface of the upper and the lower magnetic conductor plates 40 and 41. The mark C in the Figure 2A is the center plane between the two magnetic conductor plates 40 and 41. As the previous description, the dipole field makes the beam land on the imaging plane with an additional transverse shift, an additional tilt angle and the additional aberrations; the quadrupole field adds astigmatism to the beam; and the round lens field differences makes the center beam 2 and the peripheral beams 1 and 3 not focus at the same imaging plane.

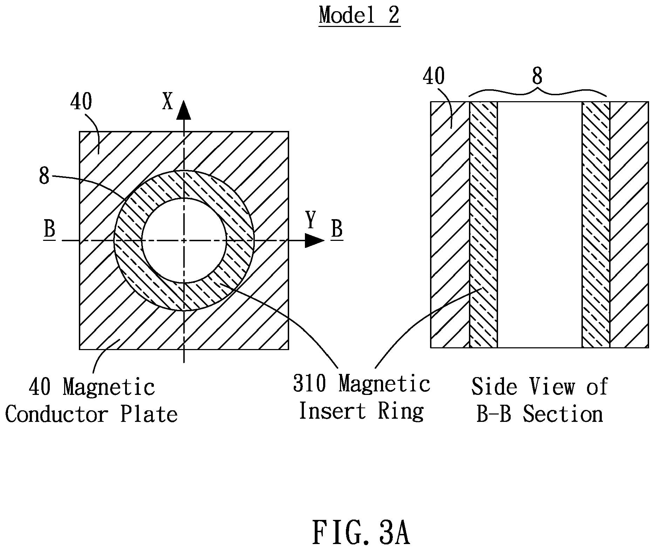

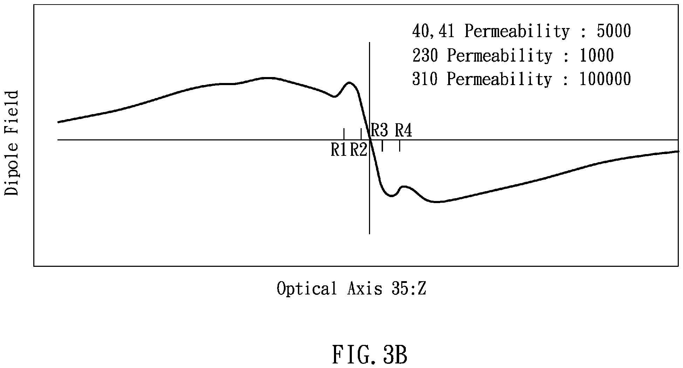

One aspect of the present invention is to insert a magnetic insert ring with a much higher permeability into each hole of each sub-lens to weaken the non-axisymmetric distribution of magnetic scalar potential in the sub-lens, and as a result reduces high order harmonics of the transverse magnetic field. Therefore, the purpose of magnetic insert rings in this invention is different from the prior art shown in US 6703624, US 2001/0028046 and JP 2002 150989 which use the magnetic insert rings to eliminate the round lens field differences among all the sub-lenses. The structure (known as such from the cited prior art) is illustrated in Figure 3A and called as Model 2. A magnetic conductor ring 310 is inserted in the hole 8 in the upper magnetic conductor plate 40 and its permeability is much higher than that of the magnetic conductor plate 40. For example the permeability of the magnetic insert ring 310 is 100,000 versus the permeability of the magnetic conductor plate 40 is 5,000. Here, the pairs of the magnetic insert rings 310 inserted in the pair of holes 8 and 9 in the upper and lower magnetic conductor plates function as a pair of pole pieces of the sub-lens 30. A simulation result of the dipole field distribution on the optical axis 35 of the sub-lens 30 is illustrated in Figure 3B, wherein permeabilities of the magnetic conductor plates 40 and 41 are 5000, coil yoke 230 is 1000, and magnetic insert rings 310 are 100000. Inserting a magnetic conductor ring with a much higher permeability lowers the peak height of the dipole field distribution between R1 and R4. The magnetic insert ring can be made of Permalloy or Supermalloy. Permalloy is the term for a nickel iron magnetic alloy. Permalloy has a high magnetic permeability, low coercivity, near zero magnetostriction, and significant anisotropic magnetoresistance. Supermalloy is also a nickel iron based alloy with even higher magnetic permeability.

Another embodiment of the present invention inserts a magnetic insert ring with a much higher permeability and a non-magnetic material gap into each hole of each sub-lens. The magnetic insert ring is aligned with the hole. The structure of this embodiment is illustrated in Figure 4A and called as Model 3. A non-magnetic material gap 420 is introduced between the inner sidewall of the hole 8 and the outer sidewall of the magnetic insert ring 310. For example, the non-magnetic material gap 420 is a gap of vacuum, or filled with a ring or a layer made of a non-magnetic material such as aluminum, copper, and ceramics. A simulation result of the dipole field distribution on the optical axis 35 of the sub-lens 30 is illustrated in Figure 4B, wherein permeabilities of plates 40 and 41 are 5000, coil yoke 230 is 1000, and magnetic insert rings 310 are lowered to 5000. Introducing the pair of non-magnetic material gaps 420 between the pair of holes and the pair of magnetic insert rings effectively reduces the dipole field between R1 and R4. The permeability of each magnetic insert ring 310 needs not be very high, for example 5000 instead of 100000. The non-magnetic material gap 420 can efficiently help to weaken the non-axisymmetric distribution of magnetic scalar potential in the sub-lens and as a result reduce high order harmonics of the transverse magnetic field. Thicknesses of the gaps 420 in the holes of sub-lenses 10, 20, and 30 can be the same or different. In this embodiment, the magnetic insert rings 310 inserted in the upper and lower magnetic conductor plates 40 and 41 function as a pair of pole pieces of the sub-lens. The thickness of the non-magnetic material gap 420 is adjusted to keep sufficiently magnetic coupling between the magnetic insert ring and the corresponding magnetic conductor plate 40 or 41 and at the same time provide more azimuthally isotropic distribution of magnetic scalar potential on the inner sidewall of the magnetic insert ring.

If the non-magnetic material gap 420 in the embodiment is configured by a multilayer gap which includes alternately placed non-magnetic material gap or layer and magnetic material gap or layer, the non-axisymmetric distribution of magnetic scalar potential in the sub-lens can be weakened much more. An example of a multilayer gap model is illustrated in Figure 4C. In the multilayer gap 430 in Fig. 4C, two non-magnetic material gaps 431 and 433 and a magnetic layer 432 are interleaved between the magnetic insert ring 310 and the magnetic conductor plates 40 or 41. In this invention, there can be two or more than two magnetic layers 432, and each magnetic layer 432 should be sandwiched by two non-magnetic material gaps.

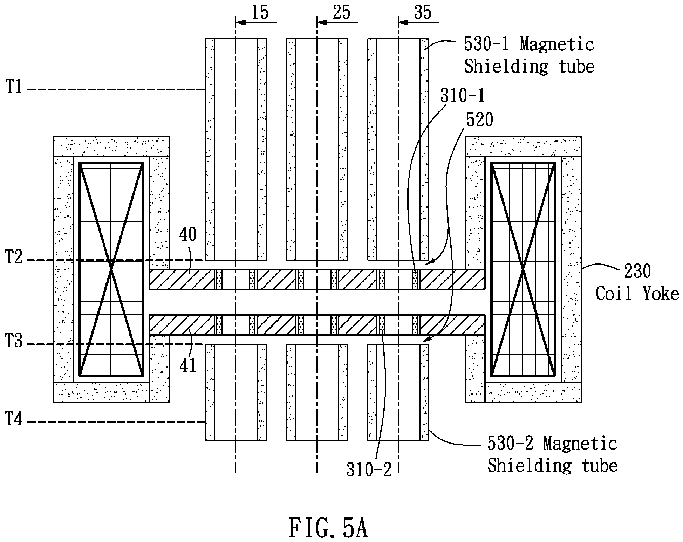

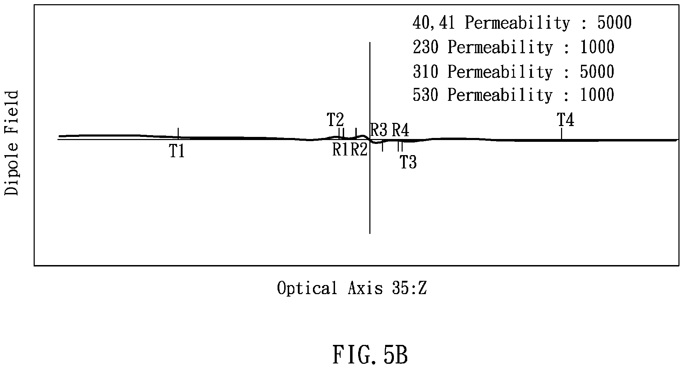

another embodiment of the present invention is illustrated in Figure 5A. Two stacks of magnetic shielding tubes 530, respectively called as 530-1 and 530-2, are introduced to the multi-axis magnetic lens. This design is for removing the magnetic fields in the area above the upper magnetic conductor plate 40 and the area below the lower magnetic conductor plate 41. Each magnetic shielding tube 530 with an inner diameter equal or larger than the outer dimensions of the non-magnetic material gap 420 is separated from the magnetic conductor plate 40 or 41 by a non-magnetic lining 520 and aligned with the corresponding magnetic insert ring 310. Four more markers are added to the drawing. T1 and T2 respectively correspond to the position inside and at the bottom end of the magnetic shielding tube 530-1 located above the upper magnetic conductor plates 40. T3 and T4 respectively correspond to the positions at the top end of and inside the magnetic shielding tube 530-2 located below the lower magnetic conductor plate 41. A simulation result of the dipole field distribution on the optical axis 35 of the sub-lens 30 is illustrated in Figure 5B, wherein permeabilities of plates 40 and 41 are 5000, coil yoke 230 is 1000, magnetic insert rings 310 are 5000, and magnetic shielding tubes 530 are 1000. The magnetic shielding tube 530 with the non-magnetic lining 520 together effectively eliminates the dipole field within the magnetic shielding tube 530 along the charged particle beam path in the sub-lens 30. The non-magnetic lining 520 is a gap of vacuum, or made of non-magnetic material such as aluminum, copper, and ceramics.

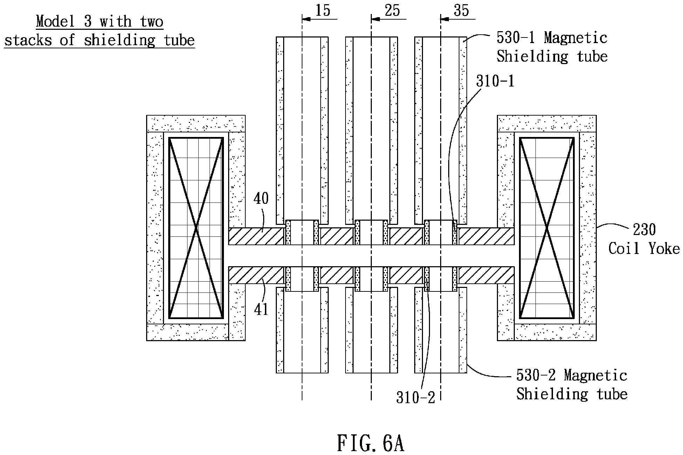

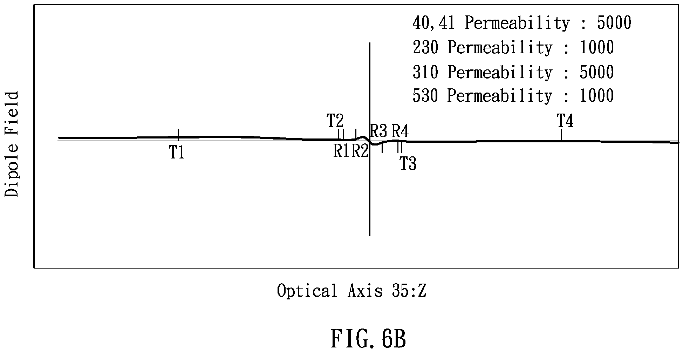

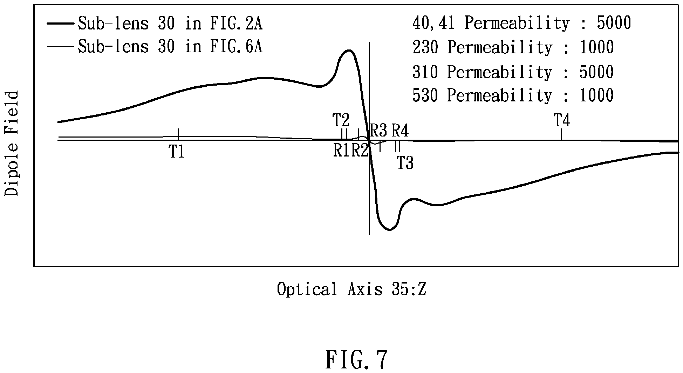

Another embodiment of the present invention is illustrated in Figure 6A. The magnetic insert ring 310-1 in the upper magnetic conductor plate 40 is extended upward into the magnetic shielding tube 530-1 and the magnetic insert ring 310-2 in the lower magnetic conductor plate 41 is extended downward into the lower magnetic shielding tube 530-2 to cover the gaps created by the non-magnetic linings 520. The extended magnetic insert ring 310-1 or 310-2 can also cover the gap from the outside of the magnetic shielding tube 530-1 or 530-2 if the outer dimension thereof is smaller than the inner diameter of magnetic insert ring 310-1 or 310-2 respectively. A simulation result of the dipole field distribution on the optical axis 35 of the sub-lens 30 is illustrated in Figure 6B, wherein permeabilities of plates 40 and 41 are 5000, coil yoke 230 is 1000, magnetic insert rings 310 are 5000, and magnetic shielding tubes 530 are 1000. Figure 7 illustrates the dipole field comparison between the original structure Model 1 in Figure 2A and the present embodiment in Figure 6A. The dipole field along the beam path is effectively reduced except the bumps between the two magnetic conductor plates 40 and 41.

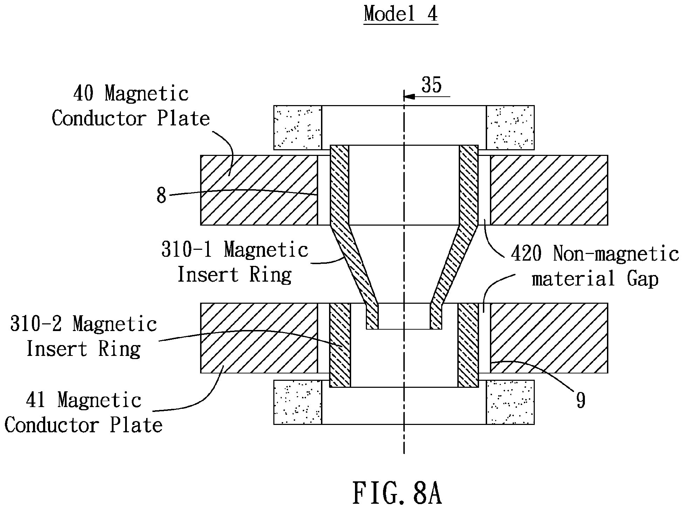

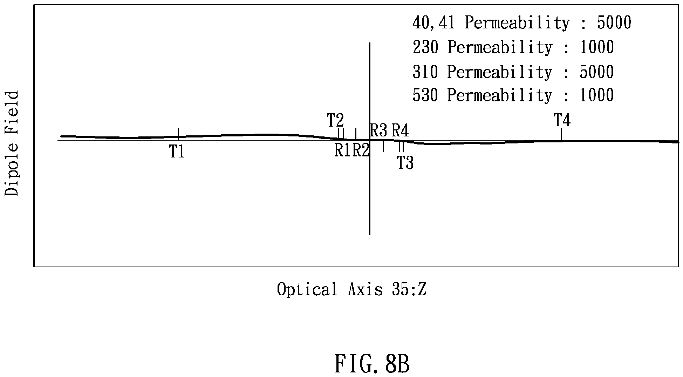

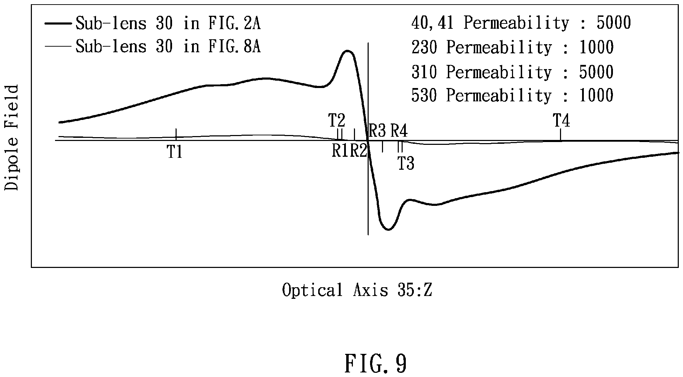

Another embodiment of the present invention is illustrated in Figure 8A. This design is for eliminating the small residual high order harmonics of the transverse magnetic field between the magnetic conductor plates 40 and 41. The magnetic insert ring 310-1 inside the upper magnetic conductor plate 40 is extended into the magnetic insert ring 310-2 inside the lower magnetic conductor plate 41. As a matter of fact, the magnetic insert rings inserted in the upper and lower magnetic conductor plates are functioned as a pair of pole pieces of the sub-lens. A simulation result of the dipole field distribution on the optical axis 35 of the sub-lens 30 is illustrated in Figure 8B, wherein permeabilities of plates 40 and 41 are 5000, coil yoke 230 is 1000, magnetic insert rings 310-1 and 310-2 are 5000, and magnetic shielding tubes 530 are 1000. The small residual dipole field between the magnetic conductor plates 40 and 41 is effectively removed. Again the Figure 9 compares the dipole field distributions of the original structure Model 1 in Figure 2A and the current structure Model 4 in Figure 8A.

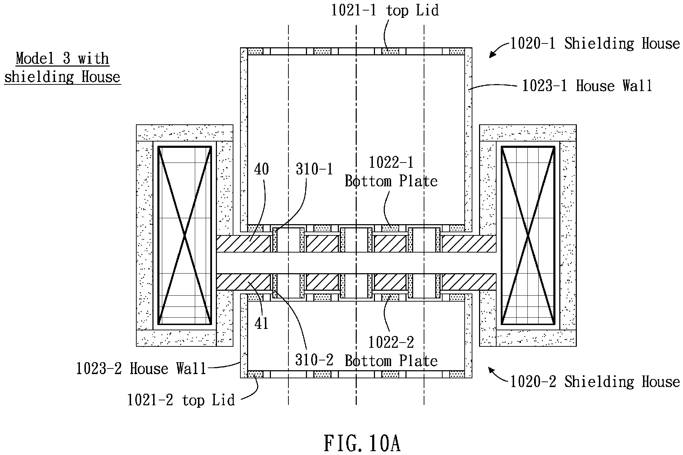

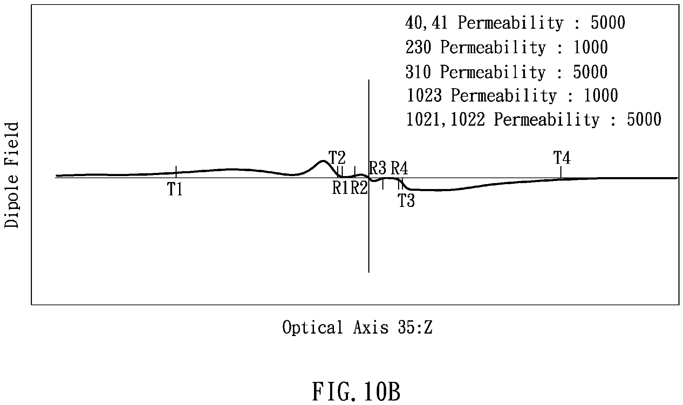

Another embodiment of the present invention is illustrated in Figure 10A. Two magnetic shielding houses 1020-1 and 1020-2 are built to cap all the sub-lenses respectively on the area above the upper magnetic conductor plate 40 and the area below the lower magnetic conductor plate 41. The idea is to build a common magnetic shielding for all the beams instead of building a magnetic shield tube for each individual beam. The simulation result of the dipole field distribution on the optical axis 35 of the sub-lens 30 is illustrated in Figure 10B, wherein permeabilities of plates 40 and 41 are 5000, coil yoke 230 is 1000, magnetic insert rings 310 are 5000, house walls 1023 (1023-1 and 1023-2) are 1000, and top lids 1021 (1021-1 and 1021-2) as well as bottom plates 1022 (1022-1 and 1022-2) are 5000.

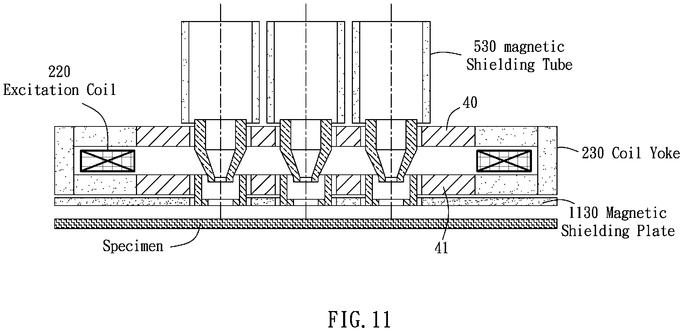

Another embodiment of the present invention is illustrated in Figure 11. The multi-axis magnetic lens of the present invention can be used in any multi-column charged particle system as condenser lens or objective lens. The excitation coil 220 and coil yoke 230 can be formed in any shape. When the multi-axis magnetic lens is utilized as an objective lens, the magnetic shielding tube 530-2 or the magnetic shielding house 1020-2 under the lower magnetic conductor plate 41 can be replaced by a magnetic shielding plate 1130 with plurality of holes. Each opening on the magnetic shielding plate 1130 is aligned with the corresponding hole in the lower magnetic conductor plate 41 and let the charged particle beam pass. The purpose is to gain a small working distance between the multi-axis magnetic lens and the specimen.

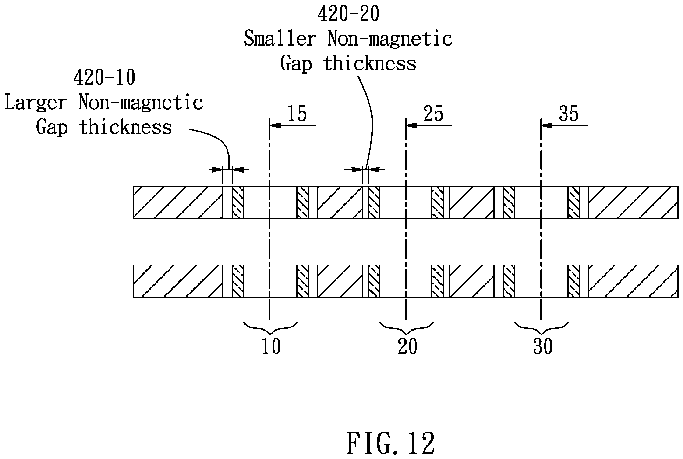

The last embodiment of the present invention is illustrated in Figure 12. As the previous discussion, the magnetic flux passing through the center sub-lens 20 is different from that of the peripheral sub-lenses 30 and 10. This difference makes the axisymmetric field component or called as round lens field of center sub-lens 20 is different from that of the peripheral sub-lenses 30 and 10. The present invention adjusts the non-magnetic material gap 420 thickness or the multilayer gap thickness in each hole to eliminate this round lens field differences among all the sub-lenses. For example, the peripheral sub-lens has a thicker non-magnetic material gap thickness than the center sub-lens in the case the peripheral sub-lens is stronger than the center sub-lens when they have the same non-magnetic material gaps.

The scope of this invention is not only limited to embody only one of the specific embodiments described above, but also a combination of different embodiments. For example, this invention can be embodied with examples in Fig. 4C, Fig. 6A, and Fig. 12 simultaneously.

With prior art, it was necessary to make the entire magnetic conductor plates with very expensive, high permeability material to reduce the dipole field along the beam paths, and it would have still been necessary to apply dummy holes and/or additional optical components to cancel the remaining non-axisymmetric transverse field components with complex calibration and adjustment for the state-of the-art applications. With the present invention employing non-magnetic material gaps, the magnetic conductor plates and the magnetic insert rings can be made with conventional, low-cost magnetic material with moderate high permeability. Structural enhancements and design tunings with the non-magnetic material gap, magnetic shielding tube, house, or plate, structure relationship between the non-magnetic material gap and other magnetic shielding structures, and multilayer structure for the non-magnetic material gap can further enhance removal of dipole field and even quadrupole field.

Although the present invention has been described in accordance with the embodiments shown, one of ordinary skill in the art will readily recognize that there could be variations to the embodiments and those variations would be within the scope of the present invention. Accordingly, many modifications may be made by one of ordinary skill in the art without departing from the scope of the appended claims.

## Claims

1. A plurality of sub-lens modules (10, 20 and 30) formed by a pair of parallel magnetic conductor plates (40 and 41) with a plurality of holes (4∼9) in pairs, wherein each hole (8) in an upper magnetic conductor plate (40) of said pair of parallel magnetic conductor plates is aligned and pairs with each corresponding hole (9) in a lower magnetic conductor plate (41) of said pair of parallel magnetic conductor plates, said plurality of sub-lens modules comprising:
a plurality of magnetic insert rings (310-1 and 310-2), each magnetic insert ring (310-1 or 310-2) inserted in and aligned with each of said plurality of holes (8 or 9);
**characterised by** a plurality of gaps (420), each gap inserted between an outer sidewall of said each magnetic insert ring (310-1 or 310-2) and an inner sidewall of said each hole (8 or 9),
wherein each pair of holes (8 and 9), two magnetic insert rings (310-1 and 310-2) therein and two gaps (420) therebetween form one sub-lens module (30) and said two magnetic insert rings functions as a pair of magnetic pole pieces thereof when a common magnetic excitation coil (220) is employed to supply a magnetic flux to said plurality of sub-lens modules.

2. multi-axis magnetic lens, comprising the plurality of sub-lens modules of claim 1, and further comprising said common excitation coil (220) adapted to provide said magnetic flux to said plurality of sub-lens modules, so that each sub-lens module focuses a charged particle beam.

3. The multi-axis magnetic lens of claim 2, wherein each of said plurality of gaps has at least one vacuum layer or is filled with one non-magnetic material layer.

4. The multi-axis magnetic lens of claim 2, further comprising a plurality of magnetic shielding tubes (530-1 and 530-2) respectively above said upper magnetic conductor plate (40) and below said lower magnetic conductor plate (41), wherein each shielding tube is aligned with each hole in each sub-lens module and is separated from each magnetic conductor plate by a vacuum gap or a non-magnetic lining (520).

5. The multi-axis magnetic lens of claim 4, wherein said each upper magnetic insert ring is extended upward into said each upper magnetic shielding tube, and said each lower magnetic insert ring is extended downward into said each lower magnetic shielding tube.

6. The multi-axis magnetic lens of claim 2, wherein said each upper magnetic insert ring is extended downward into said each lower magnetic insert ring.

7. The multi-axis magnetic lens of claim 2, further comprising two magnetic shielding houses (1020-1 and 1020-2) respectively above said upper magnetic conductor plate (40) and below said lower magnetic conductor plate (41).

8. The multi-axis magnetic lens of claim 2, further comprising a magnetic shielding plate (1130) which is placed below said lower magnetic conductor plate (41), separated from said lower magnetic conductor plate by vacuum or a non-magnetic lining (520) and having a plurality of openings respectively aligned with said plurality of holes in said lower magnetic conductor plate (41), while shielding tubes below said lower magnetic conductor plate according to claim 4, or a shielding house below said lower magnetic conductor plate according to claim 7, are absent.

9. The multi-axis magnetic lens of claim 3, wherein said plurality of gaps has same thicknesses.

10. The multi-axis magnetic lens of claim 3, wherein said plurality of gaps has different thicknesses.

11. The multi-axis magnetic lens of claim 2, wherein said each gap includes a multilayer.

12. The multi-axis magnetic lens of claim 12, wherein said multilayer comprises at least one magnetic layer and two non-magnetic layers, wherein said one magnetic layer is sandwiched between said two non-magnetic layers.

13. The multi-axis magnetic lens of claim 12, ,wherein said multilayer comprise at least two magnetic layers and at least three non-magnetic layers, wherein said magnetic layers and said non-magnetic layers are interleaved.

## Patentansprüche

1. Mehrere Teillinsenmodule (10, 20 und 30), die durch ein Paar paralleler magnetischer Leiterplatten (40 und 41) mit einer Mehrzahl von Löchern (4 ~ 9) in Paaren gebildet sind, wobei jedes Loch (8) in einer oberen magnetischen Leiterplatte (40) des Paars paralleler magnetischer Leiterplatten auf jedes entsprechende Loch (9) in einer unteren magnetischen Leiterplatte (41) des Paars paralleler magnetischer Leiterplatten ausgerichtet ist und mit ihm ein Paar bildet, die mehreren Teillinsenmodule umfassend:
eine Mehrzahl von magnetischen Einsatzringen (310-1 und 310-2), wobei jeder magnetische Einsatzring (310-1 oder 310-2) in jedes der Mehrzahl von Löchern (8 oder 9) eingesetzt und auf sie ausgerichtet ist;
**gekennzeichnet durch**
eine Mehrzahl von Zwischenräumen (420), wobei jeder Zwischenraum zwischen einer äußeren Seitenwand jedes magnetischen Einsatzringes (310-1 oder 310-2) und einer inneren Seitenwand jedes Lochs (8 oder 9) eingefügt ist,
wobei jedes Paar Löcher (8 und 9), zwei magnetische Einsatzringe (310-1 und 310-2) darin und zwei Zwischenräume (420) dazwischen ein Teillinsenmodul (30) bilden und zwei magnetische Einsatzringe als ein Paar Magnetpolstücke davon fungieren, wenn eine gemeinsame magnetische Erregerspule (220) genutzt wird, um einen magnetischen Fluss der Mehrzahl von Teillinsenmodulen zuzuführen.

2. Mehrachsen-Magnetlinse, umfassend die Mehrzahl von Teillinsenmodulen nach Anspruch 1, und ferner umfassend die gemeinsame Erregerspule (220), die angepasst ist, den magnetischen Fluss der Mehrzahl von Teillinsenmodulen zuzuführen, so dass jedes Teillinsenmodul auf einen geladenen Partikelstrahl fokussiert.

3. Mehrachsen-Magnetlinse nach Anspruch 2, wobei jede der Mehrzahl von Zwischenräumen zumindest eine Vakuumschicht aufweist oder mit einer Schicht aus nichtmagnetischem Material gefüllt ist.

4. Mehrachsen-Magnetlinse nach Anspruch 2, ferner umfassend eine Mehrzahl von magnetischen Schutzrohren (530-1 und 530-2) über der oberen magnetischen Leiterplatte (40) bzw. unter der unteren magnetischen Leiterplatte (41), wobei jedes Schutzrohr auf jedes Loch in jedem Teillinsenmodul ausgerichtet und durch einen Vakuumzwischenraum oder eine nichtmagnetische Auskleidung (520) von jeder magnetischen Leiterplatte getrennt ist.

5. Mehrachsen-Magnetlinse nach Anspruch 4, wobei jeder obere magnetische Einsatzring nach oben in jedes obere magnetische Schutzrohr hineinreicht und jeder untere magnetische Einsatzring nach unten in jedes untere magnetische Schutzrohr hineinreicht.

6. Mehrachsen-Magnetlinse nach Anspruch 2, wobei jeder obere magnetische Einsatzring nach unten in jeden unteren magnetischen Einsatzring hineinreicht.

7. Mehrachsen-Magnetlinse nach Anspruch 2, ferner umfassend zwei magnetische Schutzgehäuse (1020-1 und 1020-2) über der oberen magnetischen Leiterplatte (40) bzw. unter der unteren magnetischen Leiterplatte (41).

8. Mehrachsen-Magnetlinse nach Anspruch 2, ferner umfassend eine magnetische Schutzplatte (1130), die unter der unteren magnetischen Leiterplatte (41) angeordnet ist, die von der unteren magnetischen Leiterplatte durch Vakuum oder eine nichtmagnetische Auskleidung (520) getrennt ist und eine Mehrzahl von Öffnungen aufweist, die jeweils auf die Mehrzahl von Löchern in der unteren magnetischen Leiterplatte (41) ausgerichtet sind, während Schutzrohre unter der unteren magnetischen Leiterplatte nach Anspruch 4 oder ein Schutzgehäuse unter der unteren magnetischen Leiterplatte nach Anspruch 7 fehlen.

9. Mehrachsen-Magnetlinse nach Anspruch 3, wobei die Mehrzahl von Zwischenräumen dieselben Dicken aufweist.

10. Mehrachsen-Magnetlinse nach Anspruch 3, wobei die Mehrzahl von Zwischenräumen unterschiedliche Dicken aufweist.

11. Mehrachsen-Magnetlinse nach Anspruch 2, wobei jeder Zwischenraum eine Mehrfachschicht enthält.

12. Mehrachsen-Magnetlinse nach Anspruch 11, wobei die Mehrfachschicht zumindest eine Magnetschicht und zwei nichtmagnetische Schichten umfasst, wobei die eine Magnetschicht zwischen den zwei nichtmagnetischen Schichten liegt.

13. Mehrachsen-Magnetlinse nach Anspruch 12, wobei die Mehrfachschicht zumindest zwei Magnetschichten und zumindest drei nichtmagnetische Schichten umfasst, wobei die Magnetschichten und die nichtmagnetischen Schichten verschachtelt sind.

## Revendications

1. Pluralité de modules de sous-lentilles (10, 20 et 30) formée par une paire de plaques de conducteur magnétique parallèles (40 et 41) avec une pluralité de trous (4 ~ 9) en paires, dans laquelle chaque trou (8) dans une plaque de conducteur magnétique supérieure (40) de ladite paire de plaques de conducteur magnétique parallèles est aligné et s'apparie avec chaque trou correspondant (9) dans une plaque de conducteur magnétique inférieure (41) de la ladite paire de plaques de conducteur magnétique parallèles, ladite pluralité de modules de sous-lentille comprenant :
une pluralité de bagues d'insert magnétiques (310-1 et 310-2), chaque bague d'insert magnétique (310-1 et 310-2) étant insérée dans et alignée avec chacune de ladite pluralité de trous (8 ou 9) ;
**caractérisé par**
une pluralité d'espace (420), chaque espace étant inséré entre une paroi latérale extérieure de chaque dite bague d'insert magnétique (310-1 et 310-2) et une paroi latérale intérieure de chaque dit trou (8 ou 9),
dans laquelle chaque paire de trous (8 et 9), deux bagues d'insert magnétiques (310-1 et 310-2) à l'intérieur et deux espaces (420) entre forment un module de sous-lentilles (30) et lesdites deux bagues d'insert magnétiques fonctionnent en tant que paire de pièces à pôle magnétique de celui-ci lorsqu'une bobine (220) d'excitation magnétique commune est employée pour fournir un flux magnétique à ladite pluralité de modules de sous-lentilles.

2. Lentilles magnétiques multi-axes comprenant la pluralité de modules de sous-lentilles de la revendication 1, et comprenant en outre ladite bobine (220) d'excitation commune adaptée pour fournir ledit flux magnétique à ladite pluralité de modules de sous-lentilles, de façon à ce que chaque module de sous-lentilles concentre un faisceau de particules chargées.

3. Lentilles magnétiques multi-axes selon la revendication 2, dans lesquelles chacun de la pluralité d'espaces présente au moins une couche de vide ou est rempli d'une couche de matériau non-magnétique.

4. Lentilles magnétiques multi-axes selon la revendication 2, comprenant en outre une pluralité de tubes de blindage magnétique (530-1 et 530-2) respectivement au-dessus de ladite plaque de conducteur magnétique supérieure (40) et en-dessous de ladite plaque de conducteur magnétique inférieure (41), dans lesquelles chaque tube de blindage est aligné avec chaque trou dans chaque module de sous-lentille et est séparé de chaque plaque de conducteur magnétique par un espace de vide ou un revêtement non-magnétique (520).

5. Lentilles magnétiques multi-axes selon la revendication 4, dans lesquelles chaque dite bague d'insert magnétique supérieure est étendue vers le haut vers l'intérieur de chaque dit tube de blindage magnétique supérieur, et chaque dite bague d'insert magnétique inférieure est étendue vers le bas vers l'intérieur de chaque dit tube de blindage magnétique inférieur.

6. Lentilles magnétiques multi-axes selon la revendication 2, dans lesquelles chaque dite bague d'insert magnétique supérieure est étendue vers le bas vers l'intérieur de chaque dite bague d'insert magnétique inférieure.

7. Lentilles magnétiques multi-axes selon la revendication 2, comprenant en outre deux boîtiers de blindage magnétique (1020-1 et 1020-2) respectivement au-dessus de ladite plaque de conducteur magnétique supérieure (40) et en-dessous de ladite plaque de conducteur magnétique inférieure (41).

8. Lentilles magnétiques multi-axes selon la revendication 2, comprenant en outre une plaque de blindage magnétique (1130) qui est placée en-dessous de ladite plaque de conducteur magnétique inférieure (41), séparée de ladite plaque de conducteur magnétique inférieure par du vide ou un revêtement non-magnétique (520) et présentant une pluralité d'ouvertures alignées respectivement avec ladite pluralité de trous dans ladite plaque de conducteur magnétique inférieure (41), tandis que les tubes de blindage en-dessous de ladite plaque de conducteur magnétique inférieure selon la revendication 4 ou un boîtier magnétique en-dessous de ladite plaque de conducteur magnétique inférieure selon la revendication 7 sont absents.

9. Lentilles magnétiques multi-axes selon la revendication 3, dans lesquelles ladite pluralité d'espaces présente la même épaisseur.

10. Lentilles magnétiques multi-axes selon la revendication 3, dans lesquelles ladite pluralité d'espaces présente des épaisseurs différentes.

11. Lentilles magnétiques multi-axes selon la revendication 2, dans lesquelles chaque dit espace comprend une multicouche.

12. Lentilles magnétiques multi-axes selon la revendication 11, dans lesquelles chaque dite multicouche comprend au moins une couche magnétique et deux couches non-magnétiques, dans lesquelles ladite une couche magnétique est en sandwich entre lesdites deux couches non-magnétiques.

13. Lentilles magnétiques multi-axes selon la revendication 12, dans lesquelles chaque dite multicouche comprend au moins deux couches magnétiques et au moins trois couches non-magnétiques, dans lesquelles lesdites couches magnétiques et lesdites couches non-magnétiques sont intercalées.
